# EUROPÄISCHE PATENTSCHRIFT

(11) **EP 2 591 495 B1**
(45) Veröffentlichungstag und Bekanntmachung des Hinweises auf die Patenterteilung: **17.04.2019**
(21) Anmeldenummer: 11727469.6
(22) Anmeldetag: 27.06.2011
(51) Int. Cl.: H01L 21/00, H01L 21/67, H01L 21/306, H01L 29/06

(54) **VERFAHREN UND VORRICHTUNG ZUR HERSTELLUNG EINER RANDSTRUKTUR EINES HALBLEITERBAUELEMENTS**
METHOD AND DEVICE FOR PRODUCING AN EDGE STRUCTURE OF A SEMICONDUCTOR COMPONENT
PROCÉDÉ ET DISPOSITIF DE FABRICATION D'UNE STRUCTURE DE BORD D'UN ÉLÉMENT SEMI-CONDUCTEUR

(30) Priorität: 06.07.2010 DE 102010017751
(43) Veröffentlichungstag der Anmeldung: 15.05.2013
(73) Patentinhaber: Infineon Technologies Bipolar GmbH & Co. KG, 59581 Warstein (DE)
(72) Erfinder: BARTHELMESS, Reiner, 59494 Soest (DE); GAMON, Tobias, 59581 Warstein (DE); KELLNER-WERDEHAUSEN, Uwe, 91350 Leutenbach (DE); PIKORZ, Dirk, 59581 Warstein (DE); KUHN, Harald, 93197 Zeitlarn (DE); NEUHOFF, Oskar, 93152 Nittendorf (DE); HAUEIS, Norbert, 93138 Lappersdorf (DE); BREU, Johann, 94372 Rattiszell (DE)
(74) Vertreter: Lohmanns, Bernard
(86) Internationale Anmeldenummer: PCT/EP2011/060697
(87) Internationale Veröffentlichungsnummer: WO 2012/004147

(56) Entgegenhaltungen:
- EP-A2- 1 005 064
- EP-A2- 1 067 591
- DE-A1- 10 302 611
- GB-A- 935 484
- JP-A- 1 045 168
- US-A1- 2006 185 792
- US-A1- 2009 227 047

## Beschreibung

Die vorliegende Erfindung betrifft ein Verfahren zur Herstellung einer Randstruktur eines Halbleiterbauelements. Darüber hinaus betrifft die Erfindung ebenso eine Vorrichtung zur Durchführung dieses Herstellungsverfahrens sowie die Verwendung dieser Vorrichtung zum Ausheilen von Defekten an oberflächennahen Schichten des Halbleiterbauelements.

Randstrukturen, die auch als Randabschlüsse bezeichnet werden, dienen in hinlänglich bekannter Weise dazu, die Sperrfähigkeit von hochsperrenden Halbleiterbauelementen, wie z.B. Dioden, Thyristoren oder IGBTs dadurch zu erhöhen, dass die maximalen elektrischen Feldstärken, die üblicherweise im Randbereich des Bauelements auftreten, abgesenkt werden, um eine möglichst homogene Verteilung des elektrischen Feldes in dem Bauelement und damit eine möglichst hohe Spannungsfestigkeit des Leistungshalbleiterbauelements zu erreichen. Häufig werden derartige Randabschlüsse dadurch hergestellt, dass der Halbleiterkörper des Leistungshalbleiterbauelements in seinem Randbereich, beispielsweise im Bereich einer Ecke des Halbleiterkörpers, entfernt wird, um den Verlauf des elektrischen Feldes im Randbereich in vorteilhafter Weise zu beeinflussen. Insbesondere wird im Randbereich des Halbleiterkörpers durch eine Randabschrägung ein bestimmter Winkel eingestellt, unter dem ein pn-Übergang die Halbleiteroberfläche schneidet, wodurch der Rand von hohen elektrischen Feldstärken entlastet wird.

Um eine möglichst hohe Spannungsfestigkeit des Bauelements zu erreichen, ist es entscheidend, bei der Herstellung eines solchen Randabschlusses eine vorgegebene Form möglichst genau einzuhalten. Die hierzu eingesetzten Verfahrensschritte sind einerseits aufwändig und andererseits gestaltet sich eine exakte Reproduzierbarkeit der vorgegebenen Form häufig als schwierig. Bei herkömmlichen Verfahren werden derartige Randabschlüsse durch eine Vielzahl von Arbeitsschritten hergestellt, wobei der Halbleiterkörper zunächst in einem ersten Arbeitsschritt typischerweise mechanisch, beispielsweise durch Schleifen oder Läppen, abgeschrägt wird und anschließend in einem oder mehreren chemischen Arbeitsschritten, beispielsweise im Tauchätz- oder Rotationsätzverfahren, poliert wird, bis die gewünschte Spannungsfestigkeit erreicht ist. Insbesondere erhöht sich der Aufwand derartiger chemischer Verfahrensschritte dadurch, dass die nicht zu ätzenden Bereiche des Halbleiterkörpers, beispielsweise mittels einer Maske, vor einer Ätzwirkung geschützt werden müssen.

Aus der DE 10 2004 045 768 A1 ist ein Verfahren zur Herstellung einer Randstruktur eines Halbleiterbauelements bekannt, bei dem im Randbereich eines Halbleiterkörpers zunächst eine Phosphor enthaltende Zone hergestellt wird, die sich von einer Vorderseite des Halbleiterkörpers in den Halbleiterkörper hinein erstreckt. In einem weiteren Verfahrensschritt wird der Halbleiterkörper zumindest im Randbereich geätzt, um die Randstruktur zu erzeugen. Da die Ätzrate, mit der das Material des Halbleiterkörpers weggeätzt wird, mit zunehmender Phosphorkonzentration steigt, lässt sich die bei der Ätzung erzielbare Ätztiefe mittels einer vorgegebenen Verteilung der Phosphorkonzentration innerhalb der Phosphorzone gezielt beeinflussen.

Weitere Verfahren zur Randätzung sind etwa in den Dokumenten EP 1 005 064 A2 und US 2006/185792 A1 genannt.

Vor diesem Hintergrund hat sich die vorliegende Erfindung die Aufgabe gestellt, ein Verfahren zur Herstellung einer Randstruktur eines Halbleiterbauelements anzugeben, das im Vergleich zum Stand der Technik weniger Arbeitsschritte erfordert und mit dem eine bestimmte Kontur bzw. Form einer Randstruktur mit hoher Genauigkeit und exakter Reproduzierbarkeit hergestellt werden kann, wobei als Kontur einer Randstruktur die im Querschnitt des Halbleiterkörpers betrachtete Umrisslinie der Randstruktur zu verstehen ist. Darüber hinaus ist es Aufgabe der Erfindung, eine Vorrichtung zur Durchführung des Verfahrens bereitzustellen und ferner eine Verwendung dieser Vorrichtung zum Ausheilen von Defekten an oberflächennahen Schichten des Halbleiterbauelements anzugeben. Diese Aufgaben werden bezüglich des Verfahrens zur Herstellung einer Randstruktur eines Halbleiterbauelements gemäß Anspruch 1 und bezüglich der Vorrichtung zur Durchführung des Verfahrens gemäß Anspruch 5 gelöst. Schließlich wird die Aufgabe betreffend die Verwendung dieser Vorrichtung zum Ausheilen von Defekten an oberflächennahen Schichten des Halbleiterbauelements gemäß Anspruch 6 gelöst. Weitere, besonders vorteilhafte Ausgestaltungen der Erfindung offenbaren die Unteransprüche.

Es ist darauf hinzuweisen, dass die in den Patentansprüchen einzeln aufgeführten Merkmale in beliebiger, technisch sinnvoller Weise miteinander kombiniert werden können. Die Beschreibung charakterisiert und spezifiziert die Erfindung insbesondere im Zusammenhang mit den Figuren zusätzlich.

Zur Verdeutlichung der in dieser Beschreibung verwendeten Begriffe Hauptfläche, Rand und Randbereich seien diese zunächst beispielhaft an einem zylinderförmigen Halbleiterkörper erläutert. Bei einem zylinderförmigen Halbleiterkörper bilden die scheibenförmigen Stirnflächen die Hauptflächen des Halbleiterkörpers. Die die Hauptflächen jeweils umgebenden kreisförmigen Umfangslinien werden in dieser Beschreibung als Rand der Hauptfläche bezeichnet. Als Randbereiche sind in dieser Beschreibung jene Bereiche zu verstehen, die sich sowohl von einem Rand einer Hauptfläche entlang derselben Hauptfläche als auch von einem Rand einer Hauptfläche zu einem anderen Rand einer anderen Hauptfläche erstrecken. Mit dem erfindungsgemäßen Verfahren wird eine Randstruktur eines Halbleiterbauelements dadurch hergestellt, dass nach Bereitstellen eines Halbleiterkörpers mit wenigstens zwei Hauptflächen, die jeweils einen Rand aufweisen, und mit wenigstens einem Randbereich, der an wenigstens einen der Ränder angrenzt, ein chemisches Ätzmittel bei gleichzeitiger Rotation des Halbleiterkörpers gezielt auf wenigstens einen Randbereich des Halbleiterkörpers derart aufgetragen wird, dass die Ätzwirkung auf den Randbereich begrenzt ist.

Bevorzugt ist der Halbleiterkörper im Wesentlichen zylinderförmig und wird während des Ätzvorgangs um seine Mittelachse gedreht. Die Rotation des Halbleiterkörpers und insbesondere eine geeignet schnelle Rotation bewirkt, dass das auf den Randbereich aufgetragene Ätzmittel wieder von dem Halbleiterkörper abgeschleudert wird. Hierdurch sowie durch den gezielten Ätzmittelauftrag auf den Randbereich wird die Ätzwirkung des aufgetragenen Ätzmittels alleine auf den zu ätzenden Randbereich begrenzt. An den Randbereich angrenzende, nicht zu ätzende Bereiche des Halbleiterkörpers müssen daher nicht speziell vor einer Einwirkung des Ätzmittels geschützt werden. Damit entfällt beispielsweise das Aufbringen einer Maske auf die nicht zu ätzenden Bereiche des Halbleiterkörpers. Darüber hinaus lässt sich die Verweilzeit des Ätzmittels auf dem Halbleiterkörper und damit die von dem Ätzmittel auf die Halbleiteroberfläche entfaltete Ätzwirkung durch die Rotation und das hierdurch herbeigeführte Abschleudern des Ätzmittels in einfacher Weise steuern. Somit kann auch das Einbringen eines Dotierstoffs zur Beeinflussung der Ätztiefe entfallen.

Mit dem erfindungsgemäßen Verfahren wird eine Randstruktur und insbesondere eine gewünschte Form bzw. Kontur der Randstruktur des Halbleiterbauelements alleine durch das gezielte Auftragen des chemischen Ätzmittels auf den Randbereich des Halbleiterkörpers hergestellt. Einer mechanischen Vorbearbeitung und/oder das Aufbringen einer Maske zum Schutz der nicht zu ätzenden Bereiche des Halbleiterkörpers bedarf es bei dem erfindungsgemäßen Verfahren nicht mehr. Als mechanische Vorbearbeitung des Halbleiterbauelements ist zum Beispiel ein Abschrägen des Randbereichs beispielsweise durch Schleifen, Läppen oder Polieren zu verstehen, kann jedoch auch jedes andere Verfahren sein, das dazu geeignet ist, den Randbereich und/oder die hieran angrenzenden Bereiche des Halbleiterbauelements für die Herstellung der Randstruktur gezielt vorzubehandeln.

Somit bietet das erfindungsgemäße Verfahren den wesentlichen Vorteil, dass die Herstellung einer gewünschten Randstruktur im Vergleich zum Stand der Technik mit wesentlich weniger Verfahrensschritten auskommt. Zudem lässt sich das Auftragen des Ätzmittels auf den Randbereich des Halbleiterkörpers erfindungsgemäß derart gezielt steuern, dass eine hohe Genauigkeit der Kontur bzw. Form der Randstruktur sowie eine exakte Reproduzierbarkeit gewährleistet sind. Insbesondere ist das Verfahren gemäß der vorliegenden Erfindung bestens für die automatisierte Durchführung geeignet. Somit kann im Vergleich zum Stand der Technik ein höherer Automatisierungsgrad erzielt werden, wodurch die Fertigungsqualität der Halbleiterbauelemente gesteigert und folglich die Fehlproduktionsmenge verringert wird.

Bevorzugt erfolgt das Auftragen des chemischen Ätzmittels erfindungsgemäß durch gezieltes Einstellen und Überwachen verschiedener Ätzparameter während des Ätzvorgangs. Im Wesentlichen sind dies der Auftragungsort, die Auftragungsrichtung, die Auftragungsmenge, der Auftragungsdruck und die Auftragungstemperatur des chemischen Ätzmittels sowie die Rotationsgeschwindigkeit des Halbleiterkörpers. Diese Parameter bestimmen unmittelbar die am Auftragungsort erzielte Ätzwirkung, beispielsweise die Ätztiefe, und damit die Form bzw. Kontur der hergestellten Randstruktur. Die vorgenannten Parameter werden folglich in Abhängigkeit von der herzustellenden Form bzw. Kontur der Randstruktur bestimmt, entsprechend eingestellt und während des Ätzvorgangs überwacht und gegebenenfalls nachgeregelt. Auf diese Weise sind eine hohe Genauigkeit der Form bzw. Kontur und eine exakte Reproduzierbarkeit der Randstruktur zu gewährleisten.

Die Überwachung der Ätzparameter während des Ätzvorgangs kann beispielsweise mittels Sensormittel erfolgen. Die Form bzw. Kontur der durch den Ätzvorgang hergestellten Randstruktur lässt sich ferner beispielsweise automatisch durch visuelle Überwachungsmittel, beispielsweise mittels einer Kamera und einer automatischen Bildauswertung, daraufhin überprüfen, ob sie innerhalb vorgegebener Toleranzwerte liegt. Fehler, die während des Ätzvorgangs auftreten, lassen sich somit frühzeitig erkennen, so dass entsprechende Schritte, beispielsweise Nachbearbeitungsschritte, eingeleitet werden können.

Erfindungsgemäß wird der Auftragungsort des Ätzmittels gemäß der Erfindung während des Ätzvorgangs im Randbereich des Halbleiterkörpers verändert. Auf diese Weise ist es möglich, die Menge des auf einen bestimmten Abschnitt im Randbereich einwirkenden Ätzmittels und somit die Ätzwirkung, beispielsweise die Ätztiefe, in Abhängigkeit von dem Auftragungsort zu steuern. Hierbei ist zu berücksichtigen, dass das Ätzmittel nicht nur unmittelbar an dem Auftragungsort seine Wirkung entfaltet, sondern, bedingt durch die Rotation des Halbleiterkörpers und die hierdurch auf das Ätzmittel einwirkende Zentrifugalkraft, ebenfalls auf alle weiteren bis zum Abschleudern benetzten Bereiche des Randbereichs einwirkt.

Entsprechend dem erfindungsgemäßen Verfahren wird der Auftragungsort beim Auftragen des Ätzmittels auf einen Randbereich, der sich entlang einer Hauptfläche des Halbleiterkörpers erstreckt, in radialer Richtung verändert. Dabei wird das Auftragen des Ätzmittels an dem radial innen liegenden Abschnitt des Randbereichs begonnen und der Auftragungsort während des Ätzvorgangs radial nach außen verändert. Das Ätzmittel kann auch von radial außen beginnend nach innen aufgetragen werden. Durch die radiale Veränderung des Auftragungsorts wird innerhalb des Randbereichs wenigstens in einer Raumrichtung, nämlich in radialer Richtung, eine nicht homogene Ätzwirkung erzielt. Dies erlaubt die Herstellung einer Randabschrägung in einem bestimmten Winkel, unter dem ein pn-Übergang des Halbleiterkörpers die Halbleiteroberfläche schneidet. Hierdurch wird der Rand des Halbleiterbauelements im Betrieb von hohen elektrischen Feldstärken entlastet.

Der Auftragungsort kann jedoch während des Ätzvorgangs auch in anderen Raumrichtungen verändert werden. Beispielsweise wird in einer weiteren vorteilhaften Ausgestaltung der Erfindung das Ätzmittel auf den Randbereich des Halbleiterkörpers aufgetragen, der sich zwischen den Rändern der Hauptflächen des Halbleiterkörpers erstreckt. In diesem Fall wird der Auftragungsort des Ätzmittels bevorzugt parallel zur Rotationsachse des Halbleiterkörpers verändert. Dies ermöglicht die Herstellung einer kurvenförmigen Kontur der Randstruktur.

Besonders bevorzugt wird das Ätzmittel also derart aufgetragen, dass die Ätzwirkung wenigstens in einer Raumrichtung des Randbereichs nicht homogen ist. Dies ermöglicht die Herstellung einfacher, beispielsweise ebener Randabschrägungen, wie auch komplexer, zum Beispiel kurvenförmiger Formen bzw. Konturen der Randstruktur. Das erfindungsgemäße Verfahren ist somit besonders flexibel in der Herstellung unterschiedlicher Randstrukturen einzusetzen. Es sind lediglich die Ätzparameter an die jeweilige gewünschte Form bzw. Kontur der Randstruktur anzupassen.

Vorzugsweise wird die Auftragungsrichtung, aus der das Ätzmittel auf den Randbereich des Halbleiterkörpers aufgetragen wird, tangential in Rotationsrichtung des Halbleiterkörpers gewählt. Der tangentiale Ätzmittelauftrag in Rotationsrichtung des Halbleiterkörpers ermöglicht ein besonders präzises Auftragen des Ätzmittels, da hierdurch ungünstige Verwirbelungen und/oder Spritzer beim Auftreffen des Ätzmittels auf die Oberfläche des Halbleiterkörpers verhindert werden. Dies erlaubt folglich eine genaue, örtlich scharf abgegrenzte Ätzwirkung des aufgetragenen Ätzmittels. Die nicht zu ätzenden Bereichen des Halbleiterkörpers müssen also nicht durch zusätzliche Maßnahmen geschützt werden.

Bevorzugt wird die Auftragungsmenge des Ätzmittels bei dem erfindungsgemäßen Verfahren derart gewählt, dass der zu ätzende Randbereich des Halbleiterkörpers stets ausreichend mit Ätzmittel benetzt wird. Eine zu geringe Ätzmittelmenge führt zu einer ungleichmäßigen Ätzwirkung, beispielsweise zu Ablaufspuren auf der Halbleiteroberfläche. Eine gleichmäßige Ätzwirkung wird erfindungsgemäß dadurch erzielt, dass im Wesentlichen mehr Ätzmittel im Randbereich aufgetragen wird und somit zur Verfügung steht als für den Ätzvorgang alleine erforderlich ist. Das heißt folglich, dass die Auftragungsmenge derart bestimmt wird, dass die Halbleiteroberfläche im Randbereich zwischen dem Auftragungsort und dem Bereich, in dem das Ätzmittel wieder von dem Halbleiterkörper abgeschleudert wird, im Wesentlichen vollständig mit Ätzmittel benetzt wird. Somit ist sichergestellt, dass ausreichend Ätzmittel auf den Randbereich aufgetragen wird, um eine gleichmäßige Ätzwirkung zu erzielen.

Bevorzugt wird der Auftragungsdruck des Ätzmittels erfindungsgemäß derart gewählt, dass das Ätzmittel einerseits beim Auftreffen auf die Oberfläche des Halbleiterkörpers im Wesentlichen keine Spritzer erzeugt und andererseits einen örtlich und zeitlich genau definierten Ätzmittelauftrag ermöglicht. Bei einem zu hohen Druck führen Spritzer beim Auftreffen des Ätzmittels auf die Halbleiteroberfläche zu einer unscharfen Abgrenzung zwischen den zu ätzenden und den nicht zu ätzenden Bereichen des Halbleiterkörpers. Ein zu niedriger Druck führt zu einem undefinierten Ätzmittelstrahl und zu einer ungenauen Bestimmung des Auftragungsorts und folglich der Ätzwirkung. Erfindungsgemäß liegt der Druck des Ätzmittels zwischen etwa 0,2 bar und etwa 0,5 bar und beträgt besonders bevorzugt etwa 0,3 bar bis etwa 0,4 bar.

Da die Ätzwirkung stark von der Temperatur des Ätzmittels abhängt, ist es besonders bevorzugt, die Temperatur des Ätzmittels während des Ätzvorgangs im Wesentlichen konstant zu halten. Erfindungsgemäß liegt die Temperatur des Ätzmittels zwischen etwa 20°C und etwa 25°C und besonders bevorzugt zwischen etwa 22°C und 24°C. Hierdurch wird eine gewünschte gleichmäßige Ätzwirkung erzielt, mit der sich eine präzise Form bzw. Kontur der Randstruktur erzeugen lässt. Ferner trägt auch die bereits erwähnte kurze Verweilzeit des Ätzmittels auf dem Halbleiterkörper infolge der Rotation des Halbleiterkörpers dazu bei, dass sich die Temperatur des Ätzmittels auf der Halbleiteroberfläche im Wesentlichen nicht verändert.

Besonders bevorzugt wird die Rotationsgeschwindigkeit bei dem erfindungsgemäßen Verfahren derart gewählt, dass das auf den Randbereich des Halbleiterkörper aufgetragene Ätzmittel während des Ätzvorgangs möglichst schnell vom Halbleiterkörper abgeschleudert wird, das heißt, dass die Verweilzeit und somit die Zeit zur Entfaltung einer Ätzwirkung relativ kurz sind. Hierdurch wird in besonders vorteilhafter Weise eine gewünschte, gleichmäßige Ätzwirkung erzielt, da das Ätzmittel nicht unkontrolliert auf dem Halbleiterkörper verweilen kann. Ferner kann sich das Ätzmittel durch die Wirkung der Zentrifugalkraft auch nicht unkontrolliert auf der Halbleiteroberfläche ausbreiten, sondern wird durch sie zwischen Auftragungsort und Abschleudern über einen kontrollierbaren Abschnitt des Randbereichs gezwungen, wodurch die Ätzwirkung gezielt steuerbar ist.

Die Rotationsgeschwindigkeit ist ferner von dem Durchmesser des zu ätzenden Halbleiterkörpers bzw. dem Abstand zwischen der Rotationsachse bzw. der Mittelachse des Halbleiterkörpers und dem zu ätzenden Randbereich abhängig. Das heißt im Wesentlichen, je kleiner der Abstand zwischen der Rotationsachse bzw. der Mittelachse des Halbleiterkörpers und dem zu ätzenden Randbereich ist, desto höher ist die gewählte Rotationsgeschwindigkeit, damit in jedem Fall sichergestellt ist, dass das Ätzmittel nach dem Auftragen zügig vom Halbleiterkörper abgeschleudert wird. Darüber hinaus ist es besonders bevorzugt, die Rotationsgeschwindigkeit während des Ätzvorgangs konstant zu halten, um eine möglichst gleichmäßige Ätzwirkung über den gesamten Randbereich zu erzielen und damit eine hohe Genauigkeit der Form bzw. Kontur der Randstruktur zu erzielen.

In einer weiteren vorteilhaften Ausgestaltung des erfindungsgemäßen Verfahrens wird das Ätzmittel gleichzeitig auf zwei Randbereiche des Halbleiterkörpers aufgetragen. Somit lässt sich in einem einzigen Arbeitsschritt beispielsweise sowohl der Randbereich des Halbleiterkörpers, der sich von der ersten Hauptfläche zu dessen Rand erstreckt, als auch der Randbereich des Halbleiterkörpers, der sich von der zweiten Hauptfläche zu dessen Rand erstreckt, gleichzeitig ätzen. Dies führt in vorteilhafter Weise zu einer weiteren Verringerung der erforderlichen Arbeitsschritte, da in einem Arbeitsgang beispielsweise zwei Randstrukturen an einem Halbleiterkörper ausgebildet werden können. Ferner müssen die derart hergestellten Randstrukturen nicht zwingend dieselbe Form bzw. Kontur aufweisen.

Gemäß einer weiteren vorteilhaften Ausgestaltung des erfindungsgemäßen Verfahrens wird der Halbleiterkörper während des Auftragens des Ätzmittels durch Vakuum festgehalten und wenigstens ein Teil der nicht zu ätzenden Bereiche des Halbleiterkörpers werden mit Wasser umspült. Bevorzugt wird der Halbleiterkörper an einer seiner Hauptflächen, insbesondere in einem zentralen Bereich hiervon, mittels Vakuum festgehalten. Um zu verhindern, dass ein Teil des auf den Halbleiterkörper aufgetragenen Ätzmittels nicht von dem Halbleiterkörper abgeschleudert wird und infolge der Gravitationskraft auf die Unterseite des Halbleiterkörpers und somit in nicht zu ätzende Bereiche des Halbleiterkörpers fließt, wird ein derart zu schützender Bereich vorteilhaft mit Wasser umspült.

Weitere Merkmale und Vorteile der Erfindung ergeben sich aus den übrigen Ansprüchen sowie der folgenden Beschreibung eines nicht einschränkend zu verstehenden Ausführungsbeispiels der Erfindung, das im Folgenden unter Bezugnahme auf die Zeichnung näher erläutert wird. In dieser Zeichnung zeigen schematisch:
Fig. 1 eine Querschnittsteilansicht eines Halbleiterkörpers ohne Randstruktur,
Fig. 2 eine Querschnittsteilansicht des Halbleiterkörpers aus Fig. 1 mit einer ersten, nach dem erfindungsgemäßen Verfahren hergestellten Randstruktur an einer ersten Hauptfläche des Halbleiterkörpers,
Fig. 3 eine Querschnittsteilansicht des Halbleiterkörpers aus Fig. 1 mit einer zweiten, nach dem erfindungsgemäßen Verfahren hergestellten Randstruktur an einer zweiten Hauptfläche des Halbleiterkörpers,
Fig. 4 eine Querschnittsteilansicht des Halbleiterkörpers aus Fig. 1 mit einer dritten, nach dem erfindungsgemäßen Verfahren hergestellten Randstruktur an zwei Hauptflächen des Halbleiterkörpers,
Fig. 5 eine Querschnittsteilansicht des Halbleiterkörpers aus Fig. 1 mit einer vierten, nach dem erfindungsgemäßen Verfahren hergestellten Randstruktur an einem Randbereich, der sich zwischen den Hauptflächen des Halbleiterkörpers erstreckt,
Fig. 6 eine Vorderansicht einer Vorrichtung zur Herstellung einer Randstruktur nach dem erfindungsgemäßen Verfahren, und
Fig. 7 eine Seitenansicht der Vorrichtung aus Fig. 6.

In den unterschiedlichen Figuren sind gleiche Teile stets mit denselben Bezugszeichen versehen, so dass diese in der Regel auch nur einmal beschrieben werden.

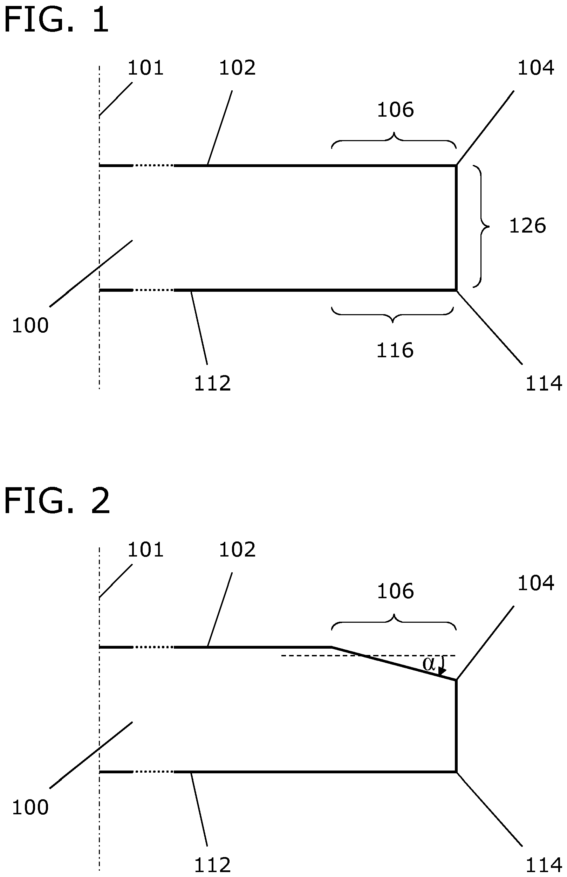

Fig. 1 stellt eine Querschnittsteilansicht eines Halbleiterkörpers 100 ohne Randstruktur dar. Der in Fig. 1 dargestellte Halbleiterkörper 100 ist im Wesentlichen zylinderförmig. Aufgrund seines symmetrischen Aufbaus ist der Halbleiterkörper 100 in Fig. 1 lediglich auf einer Seite seiner Mittelachse 101 bzw. Symmetrieachse dargestellt. Er weist eine erste scheibenförmige Hauptfläche 102 und eine zweite scheibenförmige Hauptfläche 112 auf, die jeweils zwei Stirnflächen des zylinderförmigen Halbleiterkörpers 100 bilden. Ferner sind in Fig. 1 ein erster Rand 104 und ein zweiter Rand 114 ersichtlich. Der erste Rand 104 begrenzt die erste Hauptfläche 102 und der der zweite Rand 114 begrenzt die zweite Hauptfläche 114.

Von dem ersten Rand 104 erstreckt sich ein erster Randbereich 106 radial entlang der ersten Hauptfläche 102 in Richtung der Mittelachse 101 des Halbleiterkörpers 100. Ebenso erstreckt sich von dem zweiten Rand 114 ein zweiter Randbereich 116 radial entlang der zweiten Hauptfläche 112 in Richtung der Mittelachse 101 des Halbleiterkörpers 100. Die radialen Abmessungen der Randbereiche 106 bzw. 116 sind in Fig. 1 lediglich angedeutet. Die radialen Abmessungen der Randbereiche 106 bzw. 116 bzw. das Verhältnis der radialen Abmessung der Randbereiche 106 bzw. 116 zum Gesamtradius des Halbleiterkörpers 100 hängen von verschiedenen Faktoren ab, beispielsweise von den Gesamtabmessungen des Halbleiterkörpers 100 und insbesondere von den durch die Randstruktur zu beeinflussenden elektrischen Eigenschaften. Die genauen radialen Abmessungen der Randbereich 106 bzw. 116 werden also durch die Größe und die Funktion des Halbleiterkörpers 100 bestimmt. Es ist darüber hinaus denkbar, dass die Randbereiche 106 und 116 die gleichen, aber auch unterschiedliche radiale Werte aufweisen. Des Weiteren erstreckt sich, wie in Fig. 1 dargestellt ist, zwischen den Rändern 104 und 114 ein dritter Randbereich 126. Dieser Randbereich 126 bildet im Wesentlichen die Mantelfläche des zylinderförmigen Halbleiterkörpers 100.

Mit dem erfindungsgemäßen Verfahren ist es nun möglich, ein chemisches Ätzmittel gezielt auf den Randbereich 106, 116 und/oder 126 eines im Wesentlichen wie in Fig. 1 dargestellten Halbleiterkörpers 100 bei gleichzeitiger Rotation des Halbleiterkörpers 100 um seine Mittelachse 101 derart aufzutragen, dass die Ätzwirkung auf den Randbereich 106, 116 und/oder 126 begrenzt ist. Somit lassen sich alleine durch das Auftragen des Ätzmittels unterschiedliche Konturen bzw. Formen von Randstrukturen an dem Halbleiterkörper 100 herstellen, von denen einige beispielhaft in den Fig. 2 bis 5 dargestellt sind.

Eine bevorzugte Ausgestaltung des erfindungsgemäßen Verfahrens wird nun am Beispiel einer in Fig. 2 dargestellten Randstruktur näher erläutert.

In Fig. 2 ist der Halbleiterkörper 100 mit einer nach dem erfindungsgemäßen Verfahren hergestellten Randstruktur in dem Randbereich 106 dargestellt. Die dargestellte Randstruktur ist eine Randabschrägung, bei der die Oberfläche des Halbleiterkörpers 100 in dem Randbereich 106 um einen Winkel α bezüglich der Haupterstreckungsrichtung der Hauptfläche 102 geneigt ist. Der Winkel α wird allgemein üblich in Bezug auf den Übergang von einer höher dotierten auf eine niedriger dotierte Halbleiterzone definiert. In dem in Fig. 2 dargestellten Fall spricht man von einer negativen Abschrägung des Randbereichs 106.

Die Neigung des Randbereichs 106 im Winkel α führt in bekannter Weise zu einer Krümmung des Potentiallinienverlaufs im Randbereich 106 und somit zu einer Reduzierung der Feldstärke auf der Randoberfläche. Folglich lässt sich durch diese Maßnahme die Spannungsfestigkeit im Randbereich 106 des Halbleiterbauelements erhöhen.

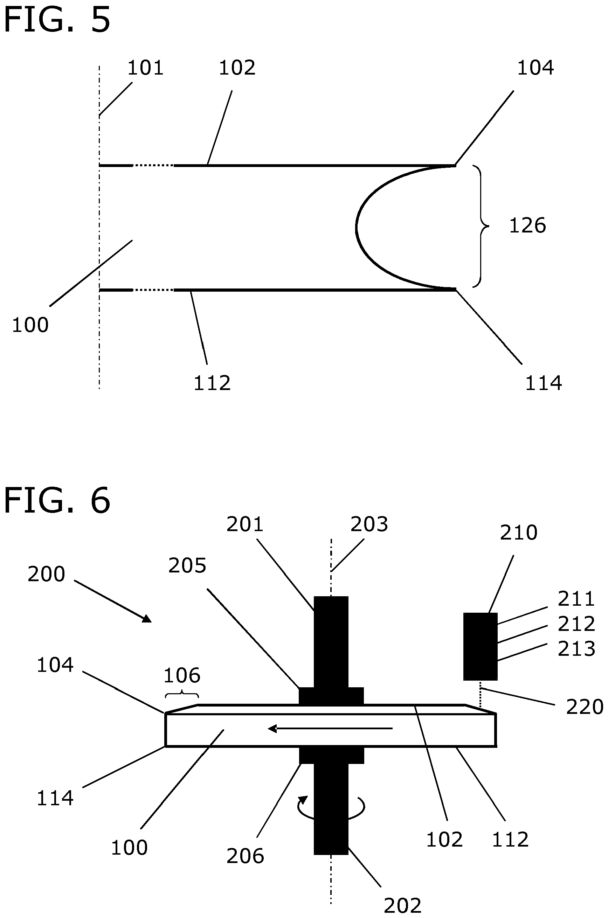

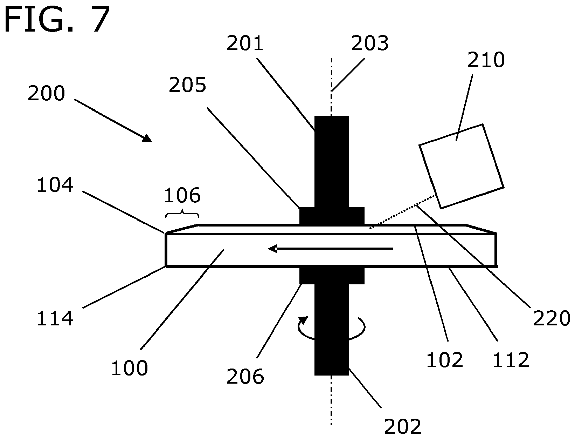

Gemäß einer bevorzugten Ausgestaltung des erfindungsgemäßen Verfahrens wird zuerst ein Halbleiterkörper 100, im Wesentlichen wie in Fig. 1 dargestellt, bereitgestellt. Der Halbleiterkörper 100 wird zwischen zwei Aufnahmemitteln 205 und 206 einer in den Fig. 6 und 7 dargestellten Vorrichtung 200 zur Durchführung des erfindungsgemäßen Verfahrens platziert. Bevorzugt wird der Halbleiterkörper 100 automatisch exakt zentriert, so dass die Mittelachse 101 des Halbleiterkörpers 100 mit der Drehachse 203 einer ersten und zweiten Spindel 201 und 202 der Vorrichtung 200 fluchtet. Durch das automatische und genaue Zentrieren des Halbleiterkörpers 100 wird die Genauigkeit der Form bzw. Kontur der herzustellenden Randstruktur wesentlich erhöht sowie eine exakte Reproduzierbarkeit der Randstruktur bei einer Vielzahl von Halbleiterbauelementen möglich.

Nachdem der Halbleiterkörper 100 zwischen die Aufnahmemittel 205 und 206 platziert wurde, nehmen diese den Halbleiterkörper 100 reibschlüssig auf. Insbesondere wird der Halbleiterkörper 100 mittels einer Klemmkraft von den Aufnahmemitteln 205, 206 gehalten. Anschließend werden die Aufnahmemittel 205 und 206 mittels der Spindeln 201 bzw. 202 um die Drehachse 203 in Rotation versetzt, somit auch der Halbleiterkörper 100 um seine Mittelachse 101, wie in Fig. 6 durch Pfeile angedeutet ist. Die Rotationsgeschwindigkeit wird durch ein Steuermittel derart eingestellt, dass das später aufgetragene chemische Ätzmittel unmittelbar nach dem Auftragen wieder von dem Halbleiterkörper abgeschleudert wird. Bei Halbleiterkörpern 100 mit kleinem Durchmesser sind folglich höhere Rotationsgeschwindigkeiten einzustellen als bei Halbleiterkörpern 100 mit einem vergleichsweise großen Durchmesser. Bevorzugt wird die einmal eingestellte Rotationsgeschwindigkeit während des anschließenden Ätzvorgangs konstant gehalten, um eine gleichmäßige und kontrollierbare Ätzwirkung des aufgetragenen Ätzmittels zu erzielen.

Vor dem Auftragen des chemischen Ätzmittels beispielsweise mittels einer in den Fig. 6 und 7 dargestellten Düsenvorrichtung 210, wird die Düsenvorrichtung in eine Startposition gefahren. Bei der beschriebenen Ausführungsform ist die Startposition der radial innen liegende Abschnitt des Randbereichs 106 des Halbleiterkörpers 100. Die Startposition könnte jedoch auch der radial außen liegende Abschnitt des Randbereichs 106, das heißt der Rand 104, sein. Über die Position und die Orientierung der Düsenvorrichtung 210 im Raum werden der Auftragungsort und die Auftragungsrichtung des Ätzmittels bestimmt. Die Düsenvorrichtung 210 wird hierzu bevorzugt wenigstens in einer Raumrichtung translatorisch und/oder um wenigstens eine Raumachse rotatorisch bewegt. Bei dem beschriebenen Ausführungsbeispiel weist die Düsenvorrichtung 210 fünf Bewegungsfreiheitsgrade auf, das heißt, die Düsenvorrichtung 210 kann in den drei Raumrichtungen X, Y und Z translatorisch und ferner um zwei Raumachsen rotatorisch bewegt werden. Als Raumachsen bzw. Drehachsen der Düsenvorrichtung 210 wurden bei dem Ausführungsbeispiel eine zur Drehachse 203 parallele Achse und eine senkrecht auf der Drehachse 203 stehende Radialachse gewählt. Somit lassen sich der Auftragungsort und die Auftragungsrichtung des Ätzmittels durch die Düsenvorrichtung 210 präzise einstellen und Randstrukturen mit unterschiedlichsten Konturen bzw. Formen mit hoher Genauigkeit herstellen.

Nachdem die Düsenvorrichtung 210 ihre Startposition erreicht hat, wird aus einer der in der Düsenvorrichtung 210 vorhandenen Düsenöffnungen 211, 212 oder 213 kontinuierlich ein chemisches Ätzmittel einer bestimmten Auftragungsmenge und mit einem bestimmten Auftragungsdruck ausgestoßen. Die verschiedenen Düsenöffnungen 211, 212 und 213 dienen bei dem hier beschriebenen Ausführungsbeispiel dazu, unterschiedliche Ätzmittel bei einem Ätzvorgang auszustoßen. Hierbei werden die Ätzmittel bevorzugt nacheinander und nicht gleichzeitig ausgestoßen. Das ausgestoßene Ätzmittel bildet einen in den Fig. 6 und 7 angedeuteten Ätzmittelstrahl 220. Dieser Strahl 220 trifft an dem vorherbestimmten Auftragungsort innerhalb des Randbereichs 106 auf die Halbleiteroberfläche auf. Wie den Fig. 6 und 7 zu entnehmen ist, verläuft die Auftragungsrichtung tangential zur und in Rotationsrichtung des Halbleiterkörpers 100. Die Auftragungsmenge des Ätzmittels wird bei dem beschriebenen Ausführungsbeispiel bevorzugt durch den Auftragungsdruck des Ätzmittels, den Durchmesser der Düsenöffnungen 211, 212 und 213 sowie die Ausstoßzeit gesteuert.

Sobald das Ätzmittel auf die Halbleiteroberfläche auftrifft, wird es infolge des sich drehenden Halbleiterkörpers 100 und der damit auf das Ätzmittel einwirkenden Zentrifugalkraft radial nach außen beschleunigt. Hierdurch fließt das Ätzmittel entlang der Oberfläche des Randbereichs 106 radial nach außen und benetzt die überflossenen Bereiche. In diesen Bereichen entfaltet das Ätzmittel seine Ätzwirkung. Nachdem das Ätzmittel den Rand 104 des Halbleiterkörpers 100 erreicht hat, wird es aufgrund der entsprechend eingestellten Rotationsgeschwindigkeit des Halbleiterkörpers 100 von dem Rand 104 abgeschleudert. Die Rotation des Halbleiterkörpers 100 bewirkt demnach eine Begrenzung der Ätzwirkung des aufgetragenen Ätzmittels auf den Abschnitt des Randbereichs 106, der sich zwischen dem Auftragungsort und dem Rand 104 des Halbleiterkörpers 100 befindet. Ein darüber hinaus gehender Schutz der radial weiter innen liegenden Abschnitte des Halbleiterkörpers 100 vor der Ätzwirkung des Ätzmittels, beispielsweise eine vor dem Ätzvorgang auf den Halbleiterkörper 100 aufgebrachte Maske, bedarf es bei dem erfindungsgemäßen Verfahren nicht mehr.

Die ausgestoßene Auftragungsmenge bestimmt sich bevorzugt derart, dass keine Ablaufspuren auf dem Halbleiterkörper 100 entstehen können, das heißt es wird bevorzugt mehr Ätzmittel auf den Halbleiterkörper 100 aufgetragen als für die zu erzielende Ätzwirkung eigentlich erforderlich wäre. Die pro Zeiteinheit aus der Düsenöffnung 211, 212 oder 213 ausgestoßene Auftragungsmenge wird während des Ätzvorgangs bevorzugt konstant gehalten, um eine gleichmäßige und kontrollierbare Ätzwirkung zu erzielen. Sie kann jedoch wahlweise auch während des Ätzvorgangs verändert werden. Wie bereits beschrieben, kann die Auftragungsmenge des Ätzmittels beispielsweise durch den Auftragungsdruck des Ätzmittels, den Durchmesser der Düsenöffnungen 211, 212 und 213 sowie die Ausstoßzeit gesteuert werden.

Der Auftragungsdruck ist bei dem beschriebenen Ausführungsbeispiel so eingestellt, dass sich ein definierter Ätzmittelstrahl 220 beim Austreten aus der Düsenöffnung 211, 212, 213 ausbildet, das heißt, dass der Ätzmittelstrahl ein gezieltes Auftragen es Ätzmittels an einem bestimmten Auftragungsort ermöglicht. Bevorzugt wird der Auftragungsdruck während des Ätzvorgangs konstant gehalten.

Sobald das chemische Ätzmittel aus der Düsenvorrichtung 210 ausgestoßen wird, beginnt sich diese mit einer bestimmten Geschwindigkeit radial von der Startposition ausgehend nach außen zu bewegen. Hierdurch wird der Auftragungsort des Ätzmittels kontinuierlich von innen nach außen verlagert. Der Auftragungsort kann auch mittels einer Drehung der Düsenvorrichtung 210 oder einer Kombination hieraus verändert werden. Durch die Verlagerung des Auftragungsorts von innen nach außen wird die Ätzwirkung des aufgetragenen Ätzmittels auf einen immer schmaler werdenden Abschnitt des Randbereichs 106 begrenzt. Über den Zeitraum des Ätzvorgangs gesehen, wirkt das aufgetragene Ätzmittel somit insgesamt länger auf die äußeren Abschnitte des Randbereichs 106 ein als auf die weiter innen liegenden. Folglich werden die äußeren Abschnitte des Randbereichs 106 stärker geätzt bzw. abgetragen als die inneren, was schließlich bei einer im Wesentlichen konstanten Änderung des Auftragungsorts zu der in Fig. 2 dargestellten Randabschrägung führt.

Falls wie oben beschrieben die Startposition der Düsenvorrichtung 210 nicht radial innen, sondern außen gewählt wird, kehren sich die Bewegungsabläufe entsprechend um, das heißt, die Düsenvorrichtung 210 wird während des Ätzvorgangs radial von außen nach innen bewegt.

Sobald die Düsenvorrichtung 210 eine Endposition erreicht hat, die dann gegeben ist, wenn der Auftragungsort des Ätzmittels im Wesentlichen den Rand 104 erreicht hat, wird kein Ätzmittel mehr aus der Düsenvorrichtung 210 ausgestoßen. Bevorzugt wird der Ätzmittelstrahl 220 unter Verwendung eines Rücksaugventils unterbrochen. So ist sichergestellt, dass kein Ätzmittel mehr unkontrolliert aus der Düsenvorrichtung 210 nachlaufen und auf den Halbleiterkörper 100 auftreffen kann. Dies führt zu einer weiteren Verbesserung der Genauigkeit der hergestellten Form bzw. Kontur der Randstruktur sowie zu einer verbesserten Reproduzierbarkeit derselben bei einer Vielzahl von Halbleiterkörpern 100.

Nach dem Erreichen der Endposition der Düsenvorrichtung 210 können sich ein oder mehrere Ätzvorgänge und/oder Reinigungsvorgänge anschließen. Hierzu wird die Düsenvorrichtung 210 im Wesentlichen wieder in ihre Startposition zurück bewegt und der Ätzvorgang unter Verwendung desselben oder eines anderen Ätzmittels oder eines Reinigungsmittels wie zuvor beschrieben wiederholt, bis die gewünschte Randstruktur hergestellt ist. Besonders vorteilhaft weist die Düsenvorrichtung 210 mehrere Düsenöffnungen 211, 212 und 213 auf, die sich beispielsweise dazu verwenden lassen, zwei unterschiedliche Ätzmittel und ein Reinigungsmittel mit derselben Düsenvorrichtung auf den Halbleiterkörper 100 aufzutragen. Bevorzugt wird vor und nach einem Ätzvorgang ein Reinigungsmittel zum Entfernen loser Partikel auf der Halbleiteroberfläche oder zum Entfernen überschüssigen Ätzmittels von der Halbleiteroberfläche mittels der Düsenvorrichtung 210 aufgetragen.

In einer weiteren vorteilhaften Ausgestaltung des erfindungsgemäßen Verfahrens werden wenigstens Teile der nicht zu ätzenden Bereiche des Halbleiterkörpers 100 während des Ätzvorgangs mit Wasser umspült. Hierzu ist wenigsten ein Aufnahmemittel 205 und/oder 206 derart ausgestaltet, dass es den zu schützenden Teil des Halbleiterkörpers bedeckt und diesen mit Wasser umspült, so dass das Ätzmittel, sollte es diesen zu schützenden Teil des Halbleiterkörpers 100 unbeabsichtigt erreichen, diese Bereiche durch das Umspülen mit Wasser vor einer Ätzwirkung geschützt sind. Besonders bevorzugt ist das Aufnahmemittel 205 und/oder 206 derart ausgebildet, dass es den Halbleiterkörper 100 sowohl mittels einer Klemmkraft festhalten als auch die von dem Aufnahmemittel 205 und/oder 206 bedeckten Bereiche des Halbleiterkörpers 100 mit Wasser umspülen kann. Der Durchmesser des Aufnahmemittels 205 und/oder 206 ist folglich entsprechend der Größe des zu schützenden Bereichs des Halbleiterkörpers 100 ausgelegt.

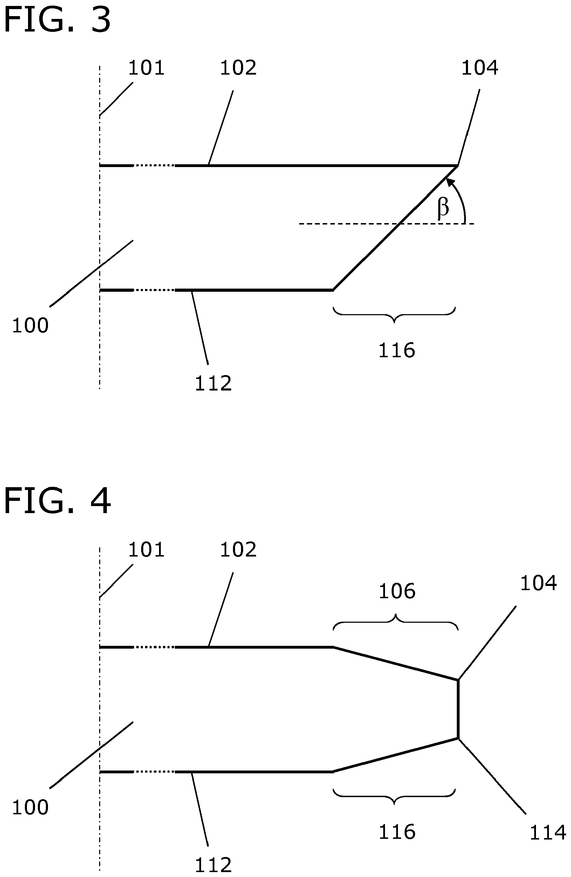

Mögliche weitere Randabschrägungen, die sich mit dem erfindungsgemäßen Verfahren herstellen lassen, sind in den Fig. 3, 4 und 5 dargestellt. Bei der in Fig. 3 veranschaulichten Randabschrägung des Randbereichs 116 des Halbleiterkörpers 100 um einen Winkel β spricht man von einer positiven Randabschrägung. Fig. 4 stellt den Fall zweier negativer Randabschrägungen sowohl im Randbereich 106 als auch im Randbereich 116 des Halbleiterkörpers 100 dar. Schließlich ist in Fig. 5 der Fall zweier positiver Randabschrägung des Halbleiterkörpers 100 im Randbereich 126 gezeigt. Selbstverständlich ist das erfindungsgemäße Verfahren zur Herstellung der Randstruktur nicht auf die in den Fig. 2 bis 5 dargestellten Fälle beschränkt. Die dort dargestellten Randstrukturen sind lediglich als veranschaulichende Beispiele für die Vielfalt der mit dem erfindungsgemäßen Verfahren herstellbaren Formen bzw. Konturen von Randstrukturen aufzufassen.

Insbesondere kann die in Fig. 5 dargestellte Randstruktur mit dem erfindungsgemäßen Verfahren hergestellt werden, indem das Ätzmittel auf den Randbereich 126 des Halbleiterkörpers 100 aufgetragen, während der Halbleiterkörper 100 wie zuvor beschrieben rotiert wird. Die Düsenvorrichtung 210 kann hierzu während des Ätzvorgangs parallel zur Oberfläche des Randbereichs 126 bewegt werden, um den Auftragungsort des Ätzmittels zu verändern. Der Auftragungsort kann selbstverständlich auch durch geeignetes Drehen der Düsenvorrichtung 210 verändert werden. Die durchzuführenden Arbeitsschritte sind im Wesentlichen dieselben, wie bereits zur Herstellung des in Fig. 2 dargestellten Randbereichs beschrieben wurde.

Fig. 6 stellt schematisch eine Vorderansicht einer Vorrichtung 200 zur Durchführung des erfindungsgemäßen Verfahrens dar. Fig. 7 stellt dieselbe Vorrichtung 200 in einer Seitenansicht dar. Die Vorrichtung 200 weist im Wesentlichen ein erstes Aufnahmemittel 205 und ein zweites Aufnahmemittel 206 zum Halten des Halbleiterkörpers 100 auf. Die Aufnahmemittel 205 und 206 werden jeweils von einer ersten bzw. zweiten Spindel 201 bzw. 202 gehalten. Die Spindeln 201 und 202 und somit auch die Aufnahmemittel 205 und 206 sind um eine Drehachse 203 drehbar gelagert. Ferner weist die Vorrichtung 200 eine bewegbare Düsenvorrichtung 210 auf, die in dem dargestellten Ausführungsbeispiel drei Düsenöffnungen 211, 212 und 213 umfasst. Mittels der Düsenöffnungen 211, 212 und 213 lassen sich bei einem Ätzvorgang aus einer vorgegebenen Position der Düsenvorrichtung 210 unterschiedliche Ätzmittel und/oder ein Reinigungsmittel auf den Halbleiterkörper 100 auftragen. In vorteilhafter Weise wird das Reinigungsmittel zu Beginn des Ätzvorgangs auf den Halbleiterkörper 100 aufgetragen, um Verunreinigungen von dem Halbleiterkörper 100 zu entfernen, die den Ätzvorgang negativ beeinflussen würden. Darüber hinaus wird das Reinigungsmittel bevorzugt zum Schluss des Ätzvorgangs aufgetragen, um überschüssiges Ätzmittel von dem Halbleiterkörper 100 zu entfernen. Somit ist sichergestellt, dass kein Ätzmittel auf der Halbleiteroberfläche verbleibt und auf diese in unkontrollierter Weise über den eigentlichen Ätzvorgang hinaus einwirkt.

Ferner umfasst die Vorrichtung 200 ein nicht dargestelltes Steuermittel, das dazu geeignet ist, die Ätzparameter wie beispielsweise den Auftragungsort, die Auftragungsrichtung, die Auftragungsmenge, den Auftragungsdruck und die Auftragungstemperatur des Ätzmittels sowie die Rotationsgeschwindigkeit des Halbleiterkörpers (100) einzustellen und während des Ätzvorgangs zu überwachen. Hierzu ist das Steuermittel mit entsprechenden Sensoren verbunden, die die vorgenannten Ätzparameter erfassen und an das Steuermittel übertragen. Darüber hinaus ist das Steuermittel mit entsprechenden Stellmitteln für die Rotationsgeschwindigkeit der Aufnahmemittel 205, 206 und die Position der Düsenvorrichtung 210 verbunden.

Die Düsenvorrichtung 210 wird von einem in den Fig. 6 und 7 nicht dargestellten, beweglichen Mechanismus gehalten. Die Position der Düsenvorrichtung 210 lässt sich bei der dargestellten Ausführungsvariante der erfindungsgemäßen Vorrichtung 200 in wenigstens einer Raumrichtung translatorisch und um wenigstens eine Raumachse rotatorisch verändern. Bevorzugt weist die Düsenvorrichtung 210 fünf Bewegungsfreiheitsgrade auf, insbesondere lässt sich die Düsenvorrichtung 210 entlang der drei Raumrichtungen X, Y und Z translatorisch bewegen und um zwei Raumachsen drehen. Als Raumachsen bzw. Drehachsen der Düsenvorrichtung 210 werden bevorzugt eine zur Drehachse 203 parallele Achse und eine senkrecht auf der Drehachse 203 stehende Radialachse gewählt. Somit lassen sich der Auftragungsort und die Auftragungsrichtung des Ätzmittels durch die Düsenvorrichtung 210 präzise einstellen und Randstrukturen mit unterschiedlichsten Konturen bzw. Formen mit hoher Genauigkeit herstellen.

Bevorzugt umfasst die Vorrichtung 200 ebenfalls ein nicht dargestelltes visuelles Überwachungsmittel, beispielsweise eine Kamera. Mittels der Kamera und einer entsprechenden Bildauswertung lässt sich die Randstruktur des Halbleiterkörpers 100 nach dem Ätzvorgang visuell daraufhin überprüfen, ob sie innerhalb vorgegebener Toleranzwerte liegt. Somit lassen sich Fehler während des Ätzvorgangs zuverlässig erkennen und die betroffenen Halbleiterbauelemente entsprechend aussortieren bzw. einer Nachbearbeitung zuführen.

In einer vorteilhaften Ausgestaltung umfasst die Vorrichtung 200 eine zweite Düsenvorrichtung. Die Verwendung von zwei Düsenvorrichtungen bietet den großen Vorteil, dass der Halbleiterkörper 100 in einem Ätzvorgang an unterschiedlichen Stellen gleichzeitig geätzt werden kann. So lassen sich in einem einzigen Arbeitsschritt gleichzeitig zwei Randbereiche 106, 116 und/oder 126 bearbeiten. Beispielsweise lassen sich auf diese Weise gleichzeitig jeweils eine Randstruktur im Randbereich 106 sowie im Randbereich 116 des Halbleiterkörpers 100 herstellen. Die zweite Düsenvorrichtung ist in diesem Fall so angeordnet, dass das Ätzmittel auf die zweite Hauptfläche 112 bzw. den Randbereich 116 des Halbleiterkörpers 100 aufgetragen werden kann, wie dies bereits für die Düsenvorrichtung 210 beschrieben wurde. Dies führt in vorteilhafter Weise zu einer weiteren Verringerung von Arbeitsschritten, da in einem Arbeitsgang beispielsweise zwei Randstrukturen dem Halbleiterkörper 100 ausgebildet werden können. Ferner müssen die Randstrukturen nicht zwingend dieselbe Geometrie aufweisen, da mehrere Düsenvorrichtungen unabhängig voneinander gesteuert werden können.

In einer weiteren vorteilhaften Ausgestaltung umfasst die Vorrichtung 200 ferner ein Zentriermittel, mit dem der Halbleiterkörper automatisch derart ausgerichtet werden kann, dass er von den Aufnahmemitteln 205, 206 exakt zentriert aufgenommen wird. Dies ist für eine hohe Herstellungsgenauigkeit und eine exakte Reproduzierbarkeit einer vorgegebenen Kontur bzw. Form der Randstruktur wesentlich.

Das erfindungsgemäße Verfahren eignet sich u.a. zur Herstellung von Randstrukturen an beliebigen hochsperrenden Halbeiterbauelementen wie beispielsweise Thyristoren, IGBTs, MOSFETs oder dergleichen.

Ferner ist das erfindungsgemäße Verfahren sowie die Vorrichtung zur Durchführung dieses Verfahrens bestens für die Verwendung geeignet, Defekte, insbesondere mechanische Defekte an oberflächennahen Schichten eines Halbleiterbauelements auszuheilen, das heißt zu entfernen. Hierzu wird eine die Defekte aufweisende Schicht eines Halbleiterkörpers wie hierin ausführlich beschrieben durch Auftragen eines chemischen Ätzmittels gezielt auf einen Randbereich des Halbleiterkörpers bei gleichzeitiger Rotation des Halbleiterkörpers entfernt. Hierdurch lässt sich die mechanische Stabilität des Halbleiterbauelements, die infolge mechanischer Defekte in dem Halbleiterkörper stark vermindert ist, die diesem beispielsweise während verschiedener Herstellungsschritte zugeführt worden sind, wieder wesentlich verbessern.

### Bezugszeichenliste

- 100: Halbleiterkörper
- 101: Mittelachse
- 102: Erste Hauptfläche
- 104: Erster Rand
- 106: Erster Randbereich
- 112: Zweite Hauptfläche
- 114: Zweiter Rand
- 116: Zweiter Randbereich
- 126: Dritter Randbereich
- 200: Ätzvorrichtung
- 201: Erste Spindel
- 202: Zweite Spindel
- 203: Drehachse
- 205: Erstes Aufnahmemittel
- 206: Zweites Aufnahmemittel
- 210: Düsenvorrichtung
- 211: Erste Düsenöffnung
- 212: Zweite Düsenöffnung
- 213: Dritte Düsenöffnung
- 220: Ätzmittelstrahl

## Patentansprüche

1. Verfahren zur Herstellung einer Randstruktur eines Halbleiterbauelements mit den folgenden Schritten:
- Bereitstellen eines Halbleiterkörpers (100), wobei der Halbleiterkörper (100) folgendes aufweist:
- wenigstens zwei Hauptflächen (102, 112), die jeweils einen Rand (104, 114) aufweisen und
- wenigstens einen Randbereich (106, 116, 126), der an wenigstens einen der Ränder (104, 114) angrenzt
- Auftragen eines chemischen Ätzmittels bei gleichzeitiger Rotation des Halbleiterkörpers (100) gezielt auf wenigstens einen Randbereich (106, 116, 126) des Halbleiterkörpers (100) derart, dass die Ätzwirkung auf den Randbereich (106, 116, 126) begrenzt ist
- **dadurch gekennzeichnet, dass** das Auftragen des Ätzmittels an dem radial innen liegenden Abschnitt begonnen und der Auftragungsort während des Ätzvorgangs radial nach außen verändert wird.

2. Verfahren nach Anspruch 1, wobei das Auftragen des chemischen Ätzmittels durch gezieltes Einstellen und Überwachen von Ätzparametern ausgewählt aus der Gruppe bestehend aus Auftragungsort, Auftragungsrichtung, Auftragungsmenge, Auftragungsdruck, Auftragungstemperatur des Ätzmittels und Rotationsgeschwindigkeit des Halbleiterkörpers (100) gesteuert wird.

3. Verfahren nach einem der vorhergehenden Ansprüche, wobei das Ätzmittel gleichzeitig auf zwei Randbereiche (106, 116, 126) aufgetragen wird.

4. Verfahren nach einem der vorhergehenden Ansprüche, wobei der Halbleiterkörper (100) während des Auftragens des Ätzmittels durch ein Aufnahmemittel (205, 206) mittels einer Klemmkraft festgehalten wird und wenigstens ein Teil der nicht zu ätzenden Bereiche des Halbleiterkörpers (100) mit Wasser umspült wird.

5. Vorrichtung zur Durchführung des Verfahrens nach einem der vorhergehenden Ansprüche, umfassend wenigstens:
- ein drehbares Aufnahmemittel (205, 206) zur Aufnahme des Halbleiterkörpers (100),
- wenigstens eine bewegbare Düsenvorrichtung (210) zum Auftragen des chemischen Ätzmittels und
- ein Steuermittel zum gezielten Einstellen und Überwachen von Ätzparametern ausgewählt aus der Gruppe bestehend aus Auftragungsort, Auftragungsrichtung, Auftragungsmenge, Auftragungsdruck, Auftragungstemperatur des Ätzmittels und Rotationsgeschwindigkeit des Halbleiterkörpers (100)
- **dadurch gekennzeichnet, dass** das Steuermittel so ausgelegt ist, dass ein Auftragen des Ätzmittels an dem radial innen liegenden Abschnitt begonnen und der Auftragungsort während des Ätzvorgangs radial nach außen verändert wird.

6. Verwendung der Vorrichtung nach Anspruch 5 zum Ausheilen von Defekten an oberflächennahen Schichten eines Halbleiterbauelements.

## Claims

1. Method for producing an edge structure of a semiconductor component comprising the following steps:
- Providing a semiconductor body (100), wherein the semiconductor body (100) comprises the following:
- at least two main surfaces (102, 112), each having an edge (104, 114), and
- at least one edge region (106, 116, 126) adjoining at least one of the edges (104, 114),
- Applying a chemical etchant while simultaneously rotating the semiconductor body (100) in a targeted manner on at least one edge region (106, 116, 126) of the semiconductor body (100) in such a way that the etching effect is limited to the edge region (106, 116, 126),
- **characterized in that** applying the etchant is begun at the radially inner section and the application location is altered radially outwards during the etching process.

2. Method according to Claim 1, wherein applying the chemical etchant is controlled by targeted setting and monitoring of etching parameters selected from the group consisting of application location, application direction, application quantity, application pressure, application temperature of the etchant and rotational speed of the semiconductor body (100).

3. Method according to either of the preceding claims, wherein the etchant is applied simultaneously on two edge regions (106, 116, 126) .

4. Method according to any of the preceding claims, wherein the semiconductor body (100) is fixedly held by a receiving means (205, 206) by means of a clamping force during the process of applying the etchant and at least one portion of the regions of the semiconductor body (100) that are not to be etched is flushed with water.

5. Device for carrying out the method according to any of the preceding claims, comprising at least:
- a rotatable receiving means (205, 206) for receiving the semiconductor body (100),
- at least one movable nozzle device (210) for applying the chemical etchant, and
- a control means for targeted setting and monitoring of etching parameters selected from the group consisting of application location, application direction, application quantity, application pressure, application temperature of the etchant and rotational speed of the semiconductor body (100),
- **characterized in that** the control means is designed such that applying the etchant is begun at the radially inner section and the application location is altered radially outwards during the etching process.

6. Use of the device according to Claim 5 for annealing defects at near-surface layers of a semiconductor component.

## Revendications

1. Procédé de fabrication d'une structure de bord d'un élément semi-conducteur avec les étapes suivantes :
- préparation d'un corps semi-conducteur (100), le corps semi-conducteur (100) présentant les traits suivants :
- au moins deux surfaces principales (102, 112), qui présentent respectivement un bord (104, 114), et
- au moins une zone de bord (106, 116, 126), qui est limitrophe d'au moins un des bords (104, 114)
- application d'un agent d'attaque chimique pendant la rotation simultanée du corps semi-conducteur (100) ciblée sur au moins une zone de bord (106, 116, 126) du corps semi-conducteur (100) de telle sorte que l'effet d'attaque est limité sur la zone de bord (106, 116, 126),
- **caractérisé en ce que** l'application de l'agent d'attaque est commencée sur la section située radialement à l'intérieur et le point d'application est modifié radialement vers l'extérieur pendant l'opération d'attaque.

2. Procédé selon la revendication 1, l'application de l'agent d'attaque chimique étant commandée par le réglage et le contrôle précis des paramètres d'attaque choisis à partir du groupe composé du point d'application, du sens d'application, de la quantité d'application, de la pression d'application, de la température d'application de l'agent d'attaque et de la vitesse de rotation du corps semi-conducteur (100).

3. Procédé selon l'une quelconque des revendications précédentes, l'agent d'attaque étant appliqué simultanément sur deux zones de bord (106, 116, 126).

4. Procédé selon l'une quelconque des revendications précédentes, le corps semi-conducteur (100) étant maintenu pendant l'application de l'agent d'attaque par un moyen de logement (205, 206) au moyen d'une force de serrage et au moins une partie des zones à ne pas attaquer du corps semi-conducteur (100) étant lavée à l'eau.

5. Dispositif pour exécuter le procédé selon l'une quelconque des revendications précédentes, comprenant au moins :
- un moyen de logement (205,206) rotatif pour recevoir le corps semi-conducteur (100),
- au moins un dispositif à buse (210) mobile pour appliquer l'agent d'attaque chimique, et
- un moyen de commande pour le réglage et le contrôle ciblés de paramètres d'attaque choisis à partir du groupe composé du point d'application, du sens d'application, de la quantité d'application, de la pression d'application, de la température d'application de l'agent d'attaque et de la vitesse de rotation du corps semi-conducteur (100),
- **caractérisé en ce que** le moyen de commande est conçu de telle sorte qu'une application de l'agent d'attaque est commencée sur la section située radialement à l'intérieur et le point d'application est modifié radialement vers l'extérieur pendant l'opération d'attaque.

6. Utilisation du dispositif selon la revendication 5 pour éliminer des défauts sur des couches proches de la surface d'un élément semi-conducteur.
